(19) Europäisches Patentamt
European Patent Office
Office européen des brevets

(11) Publication number: **0 013 492**
**B1**

(12) **EUROPEAN PATENT SPECIFICATION**

(45) Date of publication of patent specification: **09.03.83**

(51) Int. Cl.³: **H 04 R 1/18, C 01 B 35/02, C 23 C 11/00, C 23 F 1/00**

(21) Application number: **79302865.5**

(22) Date of filing: **12.12.79**

(54) **Method of producing tubular boron bodies suitable for use as pick-up cantilevers.**

(30) Priority: **12.12.78 JP 153936/78**

(43) Date of publication of application:
**23.07.80 Bulletin 80/15**

(45) Publication of the grant of the patent:
**09.03.83 Bulletin 83/10**

(84) Designated Contracting States:
**DE GB NL**

(56) References cited:
**DE - B - 1 268 931**
**GB - A - 326 899**
**US - A - 1 774 410**
**US - A - 2 528 454**
**US - A - 3 053 636**
**US - A - 3 215 439**
**US - A - 3 983 335**
**US - A - 3 985 917**

**JOURNAL OF THE ELECTROCHEMICAL SOCIETY, vol. 123, no. 2, February 1976, pages 278—285**
**L. Vandenbulcke et al.: "Chemical Vapor Deposition of Amorphous Boron on Massive Substrates"**

(73) Proprietor: **Matsushita Electric Industrial Co., Ltd.**
**1006, Oaza Kadoma**
**Kadoma-shi Osaka-fu, 571 (JP)**

(72) Inventor: **Aoki, Masaki**
**2-10-22, Namiki Kuzuha**
**Hirakata-shi, Osaka-fu (JP)**
Inventor: **Yoshida, Shigeru**
**33-17, Kitasumoto-cho**
**Kadoma-shi Osaka-fu (JP)**
Inventor: **Yamazoe, Hiroshi**
**2-7-13, Tera Katano-shi**
**Osaka-fu (JP)**
Inventor: **Nagasawa, Masahiro**
**3-13-19, Higashikori**
**Hirakata-shi Osaka-fu (JP)**

(74) Representative: **Spencer, Graham Easdale et al,**
**A.A. Thornton & CO Northumberland House 303-306, High Holborn**
**London WC1V 7LE (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

**EP 0 013 492 B1**

Courier Press, Leamington Spa, England

# Method of producing tubular boron bodies suitable for use as pick-up cantilevers

This invention relates to the production of tubular boron bodies suitable for use as cantilevers in pick-up styli (for converting shape signals recorded on a recording medium to electric signals).

Boron has a hardness next to that of diamond and a very large resistance to abrasion, so that it is useful e.g. for cutting tools, sliding components and bearings. Further, since it has a low density ($\rho$) and a large elastic modulus (E), its elastic ratio ($E/\rho$) is very large. This means that the sound wave propagation velocity in boron is very high, so that boron is particularly useful for cantilevers for supporting pick-ups.

It is difficult to obtain a dense body of boron by casting or rolling, so a boron cantilever is usually made by forming a boron coating on a substrate other than boron by vacuum deposition, sputtering or chemical vapour deposition (CVD), such that the cantilever includes the substrate in addition to boron. This is disadvantageous, because the properties of the cantilever are impaired by the substrate. Attempts have been made to chemically or physically separate the boron layer from the substrate in order to obtain a pure boron cantilever. However, there have been suggested no satisfactory methods therefor; according to the usual method, strain occurs between the boron layer and the substrate due to their differential thermal expansion, so that cracks are likely to occur in the boron layer, and thus it is difficult to obtain, with a high production yield, a boron cantilever having a high mechanical strength.

One possible way of removing a substrate is by chemically etching it away; etching agents which might be considered are aqueous solutions of acids, alkalies or salts. We have found that, in general, such etching agents attack the boron in addition to the substrate.

U.S. Patent 2528454 discloses the production of boron bodies (including tubular boron bodies) by depositing boron on a nickel wire and dissolving the wire substrate using nitric acid, aqua regia, dilute hydrochloric acid-nitric acid mixtures and cyanide solutions. Although the above U.S. patent suggests that the boron is unattacked by the above-mentioned etching agents, we have found that the degree of attack is not sufficiently low for the purpose of obtaining a tubular boron body suitable for use as a pick-up cantilever.

We have now developed an improved method of producing pure (or substantially pure) boron bodies suitable for use as tubular pick-up cantilevers, which comprises providing a wire body having thereon at least one layer applied by CVD comprising amorphous boron, $\beta$-rhombohedral boron and/or tetragonal boron, and etching the wire body by means of a solution of at least one of bromine, iodine, iodine monochloride, iodine trichloride, and iodine monobromide, so as to leave the layer applied by CVD intact in the form of a self-supporting tubular body.

The boron body produced according to the invention is of $\beta$-rhombohedral, tetragonal and/or amorphous crystal form; alpha-rhombohedral boron is unsuitable as it has insufficient mechanical strength. Amorphous boron is preferred according to the invention.

As mentioned above, the etching agent used in the method according to the invention is a solution of at least one of bromine, iodine, iodine monochloride, iodine trichloride and iodine monobromide; the solvent is preferably an alcohol, such as methanol and/or ethanol. The most preferred solvent is ethanol, in view of its lower toxicity and higher boiling point.

Solutions of bromine or iodine in methanol or ethanol are, of course, known etchants for metals and intermetallic compounds; they have not, however, been previously proposed for the purpose of etching a substrate away to leave a boron layer intact.

The alcohol solvent (which is preferably a lower alcohol) preferably has a low moisture content, since increased moisture content results in impairment of the resulting boron body. Absolute alcohol is most preferred, but an alcohol containing up to 5% moisture can be used in the method according to the invention (particularly if the boron layer is thick or the substrate is not sensitive to moisture).

Bromine is the most preferred etching agent used in the method according to the invention as it is easy to handle and has the greatest etching activity; bromine can be dissolved in the solvent simply, as it can be added in liquid form.

Iodine is actually easier to handle, but it has less etching activity; iodine (which is a solid at ambient temperature) can be readily dissolved and in this way a saturated solution can be obtained by using excess iodine. (Highest etching speeds are obtained using saturated solutions, which are therefore preferred).

Iodine trichloride, iodine monochloride and iodine monobromide are also solids and may be handled in a similar way to iodine; iodine monobromide is deliquescent but this need not be a problem. Of these three iodine compounds, iodine trichloride is the most effective etching agent (comparable to bromine); iodine monochloride is next best. The iodine compounds may be produced by dissolving iodine and chlorine (or iodine and bromine) in molecular form in the solvent.

When carrying out the etching process, the etching agent may be stirred, ultrasonically vibrated or heated to promote dissolution of the substrate. Excessive heating should be avoided, as this might cause etching of the boron an

appropriate temperature is therefore in the range 20 to 50°C.

After etching, the resulting boron body is preferably washed with, for example, an alcohol.

The wire body substrate preferably has a circular cross section, because if the form is too much complicated, it takes a long time to etch away the substrate, and further the strains in the combination of metal substrate-boron layer are likely to remain unrelieved so that cracks are likely to occur in the boron layer.

In the CVD process, a substrate is placed in a reaction chamber, heated by infrared ray heating, high frequency heating, resistor heating or current heating. Then, boron halide gas and hydrogen gas are introduced into the chamber. Thereby, boron is separated on the substrate according to the following reaction.

$$2BX_3 + 3H_2 \rightarrow 2B + 6HX$$

where X is Cl, Br or I. (Instead of boron halides, boron hydrides can be used).

The substrate is required to be refractory because the application of boron by CVD is done at a high temperature (900°C or higher). Preferable examples of substrate materials are metals such as iron, tantalum, niobium, molybdenum, tungsten and titanium because they can be formed to a complicated substrate structure and can be easily heated by current application or high frequency application. Among them, more preferable ones are tantalum, molybdenum and tungsten because they are less weakened by hydrogen in the CVD process. In order to minimize the thermal strain between the deposited boron layer(s) and the substrate, it is most preferable to use tantalum or titanium, which have thermal expansion coefficients of about 7 to 8 $\times$ $10^{-6}$/°C and about 8 $\times$ $10^{-6}$/°C, respectively, (these being closest to the thermal expansion coefficient of boron, which is 8 $\times$ $10^{-6}$/°C).

In the CVD process, a metal boride layer may be formed between the boron layer and the metal substrate. However, such a metal boride layer can also be etched away by using the above-described etchants as will be described in more detail below.

According to a preferred embodiment of the present invention, the boron layer formed by CVD is preferably on a chromium-containing layer on a metallic wire body; the chromium-containing layer may be, for example, chromium, chromium boride, an alloy of chromium plus one of iron, cobalt, nickel, zirconium, aluminium, vanadium and silicon, or a boride of such alloy. When a chromium-iron, chromium-cobalt or chromium-nickel alloy is used, it preferably contains chromium in an amount of at least 70 atom %, at least 80 atom %, or at least 90 atom %, respectively. Such a layer may be applied to the wire body by electroplating, CVD (using e.g. chromium iodide), or sputtering. The provision of such a chromium-containing layer minimises cracks in the boron layer and the obtained boron body is mechanically stronger.

The chromium-containing layer is preferably of chromium chromium boride, chromium-iron alloy or a boride of chromium-iron alloy; if a chromium alloy is used, it is preferably applied to the wire body by sputtering. There is no observable difference between a chromium boride layer formed by reacting a chromium layer with a boron halide and a chromium boride layer formed by sputtering.

The boron applied to the chromium-containing layer is preferably amorphous or $\beta$-rhombohedral.

The following experiments have been made using a chromium plate because an appropriate chromium wire is not easily available. That is, when a chromium plate was used as a metal substrate, and boron was applied by CVD on the plate, the plate was deformed by the heating of CVD. Further, since chromium has a large thermal expansion coefficient, the boron layer was cracked or broken at the end of the CVD. Similar troubles appeared when chromium of a lump form or a plate of the above-described chromium alloy was used instead of the chromium plate.

Thus, the thickness of the chromium-containing layer should be appropriately selected, depending to some extent on the thickness of the metal substrate. With a tantalum wire of circular cross-section of 200 to 300 microns diameter, the chromium-containing layer is preferably 0.1 to 20 microns thick, more preferably 0.5 to 2 microns. (A too thick layer is likely to cause cracking in the resultant boron layer, while a too thin layer may not produce the desired effect).

The wire body on which the chromium-containing layer is to be applied is preferably of tantalum, niobium, molybdenum, titanium and tungsten; tantalum is most preferred because the thermal expansion coefficient of tantalum is close to that of boron, and tantalum is little weakened by hydrogen.

As an experiment, a chromium layer about 3 microns thick was coated on a tantalum wire of diameter 250 microns, and on the chromium coated wire, boron was applied by CVD. The cross section of the thus obtained material is schematically shown in Figure 1, in which reference numeral 1 designates a tantalum wire, 2 is a boron layer, 3 is a chromium boride layer (as determined by X-ray diffraction analysis), and 4 designates an air gap. It is thus apparent that the chromium layer preliminarily coated on the tantalum wire is usually converted to chromium boride upon the deposition of boron. Sometimes, the air gap 4 is not observed by a microscopic observation.

It is considered that the effect of the chromium-containing layer is because the thermal expansion coefficient thereof is larger than that of boron, and that the bonding

between the chromium layer and the boron layer is relatively weak, resulting in a larger or smaller air gap between the chromium layer and the boron layer. Thus, the thermal strain between the metal substrate and the boron layer is relieved by the air gap, which leads to the suppression of the cracking or breaking of the resultant tubular boron cantilever and to the improvement of production yield.

According to another preferred embodiment of the present invention, an amorphous boron layer is deposited on the wire body substrate (by CVD, for example) and boron is diffused into the surface of the wire body to cause boride formation. The metal boride is, as mentioned above, etched away with the rest of the wire body in the method according to the invention.

The crystal form of boron applied by CVD can be controlled by controlling the temperature. Thus, amorphous boron is formed at 800 to 1200°C, while at above about 1200°C, borons of $\alpha$-rhombohedral form, $\beta$-rhombohedral form and tetragonal form are obtained. If the heating temperature is lower than about 800°C, the boron deposition speed by the CVD process is too low, and the deposited boron is in a powder form; it is therefore difficult to diffuse the amorphous boron into the metal substrate by heat treatment. On the other hand, if the heating temperature is above about 1200°C, $\alpha$- and $\beta$-rhombohedral borons are deposited, and it is again difficult to diffuse these into the metal substrates upon the diffusion heat treatment, which may result in cracks and/or breaks in the final tubular boron body, and also low mechanical strength and low elastic or Young's modulus.

The temperature of the heat treatment for boron diffusion should not be lower than 1200°C, because otherwise the diffusion takes too long. However, a too high temperature is also to be avoided since if it higher than 1500°C, the diffusion speed is too fast, resulting in the formation of a non-uniform metal boride layer and consequent low mechanical strength of the final boron body.

The boron layer applied on the boron-diffused metal substrate is preferably amorphous or $\beta$-rhombohedral.

In a further preferred aspect of the invention, the tubular boron body comprises two boron layers, made by application of a crystal boron layer ($\beta$-rhombohedral and/or tetragonal boron) on the wire body substrate by CVD, applying an amorphous boron layer on the crystal boron layer, and dissolving out the substrate according to the method according to the invention. The thus-formed body has a high mechanical strength and can be produced with a high yield. (A tubular boron body obtained in this way is schematically illustrated in Figure 2, in which 2' is an inner layer of crystalline boron and 2 is an outer layer of amorphous boron; see also Example 6).

The above-mentioned crystalline boron is preferably of $\beta$-rhombohedral boron of a mixed crystal of $\beta$-rhombohedral and tetragonal borons. It is preferred not to use $\alpha$-rhombohedral boron because the resultant layer surface is likely to be rough.

The first layer, i.e. crystalline boron, is preferably 0.5 to 10 microns thick. A too thin first layer is not effective for obtaining a high elasticity of the resultant tubular body, and a too thick first layer is not preferred for obtaining a high mechanical strength.

It has further been found according to this invention that a stronger boron tubular body can be obtained with a plurality of boron layers, in which each layer is in a limited thickness. The thickness of the wall of the tubular body is determined by required weight of the cantilever, required acoustic properties, etc. A tubular boron body having a certain wall thickness and composed of a plurality of boron layers is stronger than a tubular boron body having the same wall thickness composed of a single boron layer.

In this case, the thickness of each boron layer (preferably of amorphous boron) in the multi-layer structure is preferably between 3 and 15 microns. If the thickness is too small, it is difficult to produce a uniform thickness multi-layer, and it takes a long time to prepare a given thickness of the multi-layer. If the thickness is too large, crystalline boron is likely to be formed, and abnormal growth of amorphous boron is also likely to occur, resulting in a decrease of mechanical strength.

Multi-layer amorphous boron pick-up cantilevers have been made by various methods, and it has been found that the thus made cantilevers have better layer-quality than those of a mono-layer amorphous boron and it is easier to control production conditions.

The points which will be described hereinafter are directed to the CVD method for obtaining amorphous boron layers. Conventionally, in order to obtain a thick amorphous boron layer by CVD, boron is CVD-deposited at a relatively low temperature, or a large amount of starting gas is fed to a reaction chamber. In this method, the starting gas is not efficiently used and the deposited boron layer is likely to grow abnormally, and crystalline boron is likely to be produced locally, when the temperature of the metal substrate fluctuates and/or when there is a foreign matter on the metal substrate. A further disadvantage is that the mechanical strength of the deposited boron layer is low, especially when the metal substrate is removed e.g. by etching.

In forming the boron layers by CVD for use according to the present invention, the thermal energy applied to the wire body substrate is preferably gradually increased while the rate of flow of gas is kept constant, the thermal energy supply being cut off when the temperature of the wire body substrate reaches to a predetermined temperature. By this means, a

plurality of amorphous boron layers can be formed on the wire body, and the temperature of the wire body (i.e. the predetermined temperature) can be higher than the conventional upper limit temperature for producing an amorphous boron layer. That is, according to the conventional method, when the temperature is above the upper limit, crystalline boron is formed, while according to the method just described the predetermined temperature need not be kept for a long time, so that the formation of crystalline boron can be prevented. Amorphous borons made at a higher reaction temperature have better layer properties than those made at a lower reaction temperature.

When the substrate is gradually heated as described, amorphous boron starts to deposit when a predetermined temperature is reached. When the heating is stopped the substrate temperature soon rapidly decreases, whereby boron deposition is stopped. The thus deposited boron layers may be of uniform amorphous boron without any abnormal growth or local crystallization.

Each amorphous boron layer thus formed (in one cycle) is generally thin, because the time for which the amorphous boron is deposited is short. In order for each amorphous boron layer to be relatively thick, the substrate should be kept for a certain time at the predetermined temperature before cut-off of the thermal energy supply, since while the substrate is kept at the predetermined temperature, boron continues to deposit on the substrate. The time for which the predetermined temperature can be maintained depends on the predetermined temperature (if too long, abnormal growth of boron is likely to occur).

The above-described method is effective in both the cases of CVD at reduced pressure and ordinary pressure. By using a higher substrate temperature, the starting gas can be more efficiently utilized. As a modification of this method, the first layer on the substrate can be crystalline boron (e.g. 0.5 to 10 microns thick), with the remaining plurality boron layers being amorphous boron layers. Such a structure is also stronger than the conventional structure and has improved appearance.

In order that the present invention may be more fully understood, the following Examples are given by way of illustration only.

### Example 1

Using a mixed gas of boron trichloride and hydrogen, a boron layer of 100 microns thick was deposited on a tantalum wire of diameter 300 microns by CVD, the temperature of the wire being maintained at 1300°C by electrically heating the wire.

X-ray diffraction analysis showed that the thus deposited boron layer was crystalline.

The coated wire was cut into wire segments by planes perpendicular to the axis of the wire by using a YAG laser. The wire segments were immersed in various etchants as listed in Table 1. The etchants were each put in a sealed container to prevent ingress of moisture from the ambient air and to prevent evaporation. Each etchant was kept at room temperature and was supplied with constant ultrasonic vibrations. Table 1 shows the time required for completely dissolving the wire in each wire segment, and the mechanical strength of each resulting tubular body. (The mechanical strength as measured herein is the minimum load required for breaking each tubular body when both ends thereof are supported with a load applied to the centre of the body).

It is apparent from Table 1 that the etchants used in the method according to this invention are superior to others, and that among them, the best ones are those containing bromine and iodine trichloride. These etchants can dissolve not only tantalum but also tantalum boride.

By using the same etchants as those above and by using W, Ni, Ti, Mo, Fe and stainless steel instead of tantalum, similar experiments to those done above were performed. Thereby it was found that satisfactory tubular boron bodies were obtained according to this invention, although the properties were a little inferior to those obtained using tantalum.

Similar results were obtained when absolute ethanol was used instead of absolute methanol; when the wire was of iron or stainless steel, good results were also obtained using commercially available alcohol instead of absolute methanol, although the etching speed was a little slower.

As to the substrates of W, Ni, Ti, Mo, Fe and stainless steel, selective etching of the substrates was tried using appropriate acids and alkaline liquids. However, in all such cases, the boron layers were very much damaged thereby.

The elastic ratio of each of the tubular boron bodies obtained according to this invention was about 15 × $10^8$ cm.

### Example 2

Four tantalum wires each of 250 microns diameter were heated by an appropriate means to various temperatures listed in Table 2 in a CVD reaction chamber, and on each of such wires, a boron layer of 50 microns was applied by CVD as in Example 1. Each of the thus treated wires was cut into several wire segments as in Example 1, and each wire segment was immersed for 20 hours in an etchant made by adding 25 grams of bromine in 100 ml of absolute methanol and stirring it. During immersion in the etchant, the etchant was ultrasonically agitated.

The properties of the resulting tubular boron bodies are given in Table 2. As will be seen, satisfactory mechanical strengths can be obtained with various crystal forms of boron. However, it is also apparent from Table 2 that the mechanical strength depends on the crystal

form of boron. Further, the elastic ratios of the tubular boron bodies were similar to the elastic ratios obtained in Example 1 although the elastic ratios obtained here were a little different from each other depending on the crystal form of the boron. The elastic ratios were in the range $13 \times 10^8$ to $15 \times 10^8$ cm when the bodies had sufficient mechanical strength; it is thus unnecessary to separately measure the elastic ratio.

Example 3

Seventeen tantalum wires each of 300 microns diameter were provided. On the wires, except one, chromium and chromium boride were coated to various thicknesses and by various coating methods as listed in Tables 3A and 3B. On each of the thus treated sixteen wires and the remaining one wire, a crystalline boron layer 70 microns thick was deposited by CVD. By cutting each wire by a plane perpendicular to the wire axis, several wire segments each of about 10 mm were made. Each of the thus made seventeen kinds of wire segments was immersed in an etchant for 50 hours in a similar manner to that of Example 1, in order to remove the metal substrate and thereby make a tubular boron body.

The mechanical strengths and the production yields of the resulting tubular boron bodies are listed in Tables 3A and 3B. It is apparent from these tables that the chromium coating contributes to strengthening the tubular boron bodies.

When tantalum was replaced by W, Ti, Ni and Mo, the chromium coating including chromium boride also contributed to the strengthening of resultant boron pipes, although the strengthening effect was a little less than that in the case of tantalum. Care should be taken to select appropriate preparation conditions for obtaining good tubular boron bodies, because mutual diffusion between chromium and the metal substrate becomes remarkable at high temperatures.

When an amorphous boron layer was deposited on the metal substrate instead of a crystalline boron layer, similar contribution of the chromium coating to the strengthening of a resultant tubular boron body was confirmed.

Example 4

Twenty-four tantalum wires each of 200 microns diameter were provided. On these wires, except two, chromium, alloys of chromium with iron, cobalt, nickel, zirconium, aluminium, vanadium and silicon and their borides were coated by various coating methods as listed in Table 4. On each of these twenty-four wires, layers of crystalline boron and amorphous boron each of 30 microns were applied by CVD. Each wire was cut into wire segments each of 3 mm length, and the wire segments were immersed in an etchant so as to remove the metal and obtain tubular boron bodies. Table 4 lists the thickness of each chromium coating, production yield of each case, mechanical strength of each tubular boron body and the crystal form of each boron layer.

As apparent from Table 4, the chromium coatings contribute to the strengthening of the resultant boron bodies. Among the various chromium coatings, chromium-iron alloy and its boride are most effective for the purpose to about the same extent as in the case of chromium and its boride. The preferred amount of iron in a chromium-iron alloy is up to 30 atom %; the preferred amount of cobalt in chromium-cobalt alloy is up to 20 atom %; and the preferred amount of nickel in chromium-nickel alloy is up to 10 atom %. (These preferred amounts apply also to the borides). In the cases of alloys of chromium each with zirconium, aluminium, vanadium and silicon and their borides, the amount of chromium therein is preferably from 20 to 100 atom %.

If chromium is not used and iron, cobalt or nickel is used as a coating on the tantalum metal substrate, the desired effect of the coating may be obtained, but such coating has a disadvantage that it is difficult to control the CVD conditions.

When each of W, Ti, Ni and Mo was used instead of tantalum and was subjected to the same experiments as done above, satisfactory tubular boron bodies were obtained, although some of the boron bodies were a little inferior to those obtained using tantalum.

The thus obtained tubular boron bodies in this Example had elastic ratio values each of about $15 \times 10^8$ cm.

Care should be taken to select appropriate preparation conditions for obtaining good tubular boron bodies because diffusion between the chromium coating and the metal substrate becomes high at high temperatures.

As apparent from this Example, chromium coatings are effective irrespective of the method of dissolving the metal substrate, but best results are obtained by etching according to the invention.

Example 5

Two tungsten wires and twelve tantalum wires each of 400 microns diameter were provided. On each of the wires, a boron layer of 60 microns thick was applied by CVD as follows. First, a thin amorphous layer was applied by CVD and then heated so as to diffuse all the boron into the wire. (This deposition and diffusion process usually takes no more than a few minutes). Next, a boron layer 60 microns thick was CVD-deposited on the thus treated wire, which was cut into wire segments. These were then treated with etchant to obtain tubular boron bodies; features of the method and the properties of the boron bodies are listed in Table 5. The thus obtained boron bodies each had an elastic ratio of about $14 \times 10^8$ cm.

It is apparent from Table 5 that mechanically

strong tubular boron bodies can be obtained according to the invention.

The preferred temperature for forming the first amorphous boron layer is 900 to 1100°C, and the preferred temperature for diffusing the first amorphous layer into the wire is 1200 to 1300°C.

It should be noted that sample Nos. 1 to 3 of Table 5 are comparative samples (not according to the invention). The mechanical strengths in the Table are defined as relative values on the basis that the mechanical strength of a tubular β-rhombohedral boron body made by a conventional method using a tungsten wire as a metal substrate is 100.

It was confirmed that the three processes in this method could be done at either ambient gas pressure or a reduced gas pressure, for obtaining similar results, although the reduced gas pressure is more preferable e.g. because the temperature uniformity of the metal substrate is better. Further this method is applicable for a wire substrate having any cross section.

Example 6

Two tungsten wires and ten tantalum wires each of 200 microns diameter were provided. A crystalline boron layer was applied by CVD on each of nine wires at a high temperature, and on the thus deposited crystalline boron layer, an amorphous boron layer was applied by CVD at a lower temperature. The thus obtained double boron layer had a thickness of 30 microns. On each of the other three wires, a single crystalline boron layer or a single amorphous boron layer was applied by CVD. Each of the thus treated wires was cut into wire segments, and these wire segments were etched to produce tubular boron bodies.

Table 6 lists the structure of the boron layers of the thus obtained boron bodies, and the measured mechanical strengths thereof, wherein each mechanical strength therein is a relative value on the basis that the mechanical strength of the β-rhombohedral boron pipe made from a tungsten wire substrate is 100. In Table 6, sample Nos. 1 to 3 are comparative samples (not according to the invention).

It is apparent from Table 6 that the tubular boron obtained according to the invention has excellent mechanical strength; the elastic ratio of each of the boron bodies thus obtained was about $14 \times 10^8$ cm. The preferred thickness of the crystalline boron layer in the double boron layer is 2 to 10 microns.

It was further confirmed that similar results could be obtained irrespective of whether the CVD atmosphere had a reduced pressure or ambient pressure, and whether the cross section of the metal substrate was rectangular or of any other form.

Example 7

Two tungsten wires and even tantalum wires each of 150 microns diameter were provided. On each of the wires, an amorphous boron layer of 60 microns of either single layer structure or multi-layer structure was applied by CVD by either performing a long continuous CVD or by intermittent CVD as described above. Each wire was then cut into wire segments, and these wire segments were etched to produce tubular boron bodies. Table 7 lists the thickness of the single amorphous layer or each layer in the amorphous multi-layers, and the measured mechanical strengths of the boron bodies. In Table 7, sample Nos. 1 and 2 are comparative samples (not according to the invention). The mechanical strengths shown therein are relative values on the basis that the mechanical strength of the amorphous single layer of 60 microns made by using a tungsten wire substrate is 100.

It is apparent from Table 7 that the tubular boron bodies obtained according to the invention have high mechanical strength. Each of the boron bodies had an elastic ratio of $14 \times 10^8$ to $16 \times 10^8$ cm.

It was formed that similar good results could be obtained regardless of the gas pressure in CVD and of the cross section of the wire substrate.

TABLE 1

| No. | Substrate | Etchant | Etching | | Mechanical strength | Comment |
|---|---|---|---|---|---|---|
| | | | Required etching | Comment | | |
| 1 | Ta | aqueous solution of HF – | over 48hr | boron is broken at 48hr | – | boron is completely broken finally |
| 2 | Ta | aqueous solution of KOH + $H_2O_2$ | over 120hr | – | – | – |
| 3 | Ta | 100ml absolute methanol* plus 25g bromine | about 15hr | good | high | – |
| 4 | Ta | absolute methanol* saturation solution of iodine | about 75hr | good | high | – |
| 5 | Ta | 100ml absolute methanol* plus 25g ICl | about 30hr | good | a little high | – |
| 6 | Ta | absolute methanol* saturation solution of $ICl_3$ | about 15hr | good | high | – |
| 7 | Ta | 100ml absolute methanol* plus 25g IBr | about 70hr | good | a little high | – |

*Commercially available absolute methanol for Karl Fischer measurement.

TABLE 2

| No. | Substrate temperature | Crystal forms of boron | Etching | Mechanical strength |
|---|---|---|---|---|
| 1 | 1100°C | amorphous (non-crystal) | Boron is a little likely to break by etching | high |
| 2 | 1150°C | amorphous plus α-rhombohedral | Boron is a little likely to break by etching | medium |
| 3 | 1250°C | β-rhombohedral | Boron hardly breaks by etching | high |
| 4 | 1350°C | β-rhombohedral plus tetragonal | Boron hardly breaks by etching | medium |

TABLE 3A

| No. | Chromium coating method | Thickness of chromium layer | Production yield after etching | Mechanical strength |
|---|---|---|---|---|
| 1 | none | 0.micron | about 10% (most are broken by etching) | low |
| 2 | DC.sputtering | 1.5microns | about 100% | high |
| 3 | AC.sputtering | 1.0micron | about 100% | high |
| 4 | DC sputtering of 0.2 micron Fe and then Cr plating | 8.0microns | about 85% | a little high |
| 5 | CVD ($CrI_2 + H_2 \rightarrow Cr + 2HI$) | 2.0microns | about 100% | high |
| 6 | AC sputtering | 0.1micron | about 20% (many are broken by etching) | low |
| 7 | AC sputtering | 0.4micron | about 80% | a little high |
| 8 | AC sputtering | 0.5micron | about 100% | high |
| 9 | AC sputtering | 4.5microns | about 100% | high |
| 10 | AC sputtering | 6.0microns | about 100% | a little high |

TABLE 3B

| No. | Chromium coating method | Thickness of chromium layer | Production yield after etching | Mechanical strength |
|---|---|---|---|---|
| 1 | DC sputtering of Cr and then boronizing using $BCl_3$ | 1.2microns | about 100% | high |
| 2 | AC sputtering of Cr and then boronizing using $BCl_3$ | 1.0micron | about 100% | high |
| 3 | AC sputtering of Cr and then boronizing using $BCl_3$ | 0.35micron | about 30% (many are broken by etching) | low |
| 4 | AC sputtering of Cr and then boronizing using $BCl_3$ | 0.53micron | about 100% | high |
| 5 | AC sputtering of Cr and then boronizing using $BCl_3$ | 3.microns | about 100% | high |
| 6 | AC sputtering of Cr and then boronizing using $BCl_3$ | 4.5microns | about 100% | high |
| 7 | AC sputtering of Cr and then boronizing using $BCl_3$ | 7.0microns | about 100% | a little high |

TABLE 4

| No. | Coating material | Coating method | Thickness of coating layer (micron) | Production yield | Mechanical strength | Crystal form of boron |
|---|---|---|---|---|---|---|
| 1 | none | – | – | 3% | low | mainly amorphous |
| 2 | none | – | – | 10% | low | mainly β-rhombohedral |
| 3 | Cr | r.f. sputtering | 0.8 | 92% | high | mainly amorphous |
| 4 | alloy of Cr (90at%) plus Fe(10at%) | r.f. sputtering | 0.7 | 91% | high | Mainly amorphous |
| 5 | alloy of Cr (75at%) plus Fe(25at%) | r.f. sputtering | 0.85 | 94% | high | Mainly amorphous |
| 6 | alloy of Cr (50at%) plus Fe(50at%) | r.f. sputtering | 1.0 | 60% | high | Mainly amorphous |
| 7 | alloy of Cr (25at%) plus Fe(75at%) | r.f. sputtering | 1.0 | 40% | a little low | Mainly amorphous |
| 8 | Cr | r.f. sputtering | 0.9 | 100% | high | Mainly β-rhombohedral |
| 9 | alloy of Cr (90at%) plus Fe(10at%) | r.f. sputtering | 0.7 | 100% | high | Mainly β-rhombohedral |
| 10 | alloy of Cr (75at%) plus Fe(25at%) | r.f. sputtering | 0.8 | 100% | high | Mainly β-rhombohedral |
| 11 | alloy of Cr (50at%) plus Fe(50at%) | r.f. sputtering | 1.0 | 83% | high | Mainly β-rhombohedral |
| 12 | alloy of Cr (25at%) plus Fe(75at%) | r.f. sputtering | 1.0 | 58% | a little low | Mainly β-rhombohedral |
| 13 | Cr boride | Cr r.f. sputtering and then boronizing using $BCl_3$ | 1.2 | 98% | high | Mainly β-rhombohedral |

TABLE 4 (Continued)

| No. | Coating material | Coating method | Thickness of coating layer (micron) | Production yield | Mechanical strength | Crystal form of boron |
|---|---|---|---|---|---|---|
| 14 | boride of alloy of Cr (75at%) plus Fe(25at%) | alloy r.f. sputtering and then boronizing using $BCl_3$ | 1.1 | 99% | high | Mainly β-rhombohedral |
| 15 | alloy of Cr (95at%) plus Ni(5at%) | r.f. sputtering | 1.5 | 92% | high | Mainly amorphous |
| 16 | alloy of Cr (90at%) plus Ni(10at%) | r.f. sputtering | 0.9 | 80% | high | Mainly amorphous |
| 17 | alloy of Cr (60at%) plus Ni(40at%) | r.f. sputtering | 0.9 | 50% | a little low | Mainly amorphous |
| 18 | alloy of Cr (90at%) plus Co(10at%) | r.f. sputtering | 1.3 | 100% | high | Mainly β-rhombohedral |
| 19 | alloy of Cr (80at%) plus Co(20at%) | r.f. sputtering | 1.1 | 90% | high | Mainly β-rhombohedral |
| 20 | alloy of Cr (50at%) plus Co(50at%) | r.f. sputtering | 1.0 | 60% | a little low | Mainly β-rhombohedral |
| 21 | alloy of Cr (80at%) plus Zr(20at%) | r.f. sputtering | 1.0 | 93% | high | Mainly amorphous |
| 22 | alloy of Cr (80at%) plus Al(20at%) | r.f. sputtering | 1.5 | 92% | high | Mainly amorphous |
| 23 | alloy of Cr (80at%) plus V (20at%) | r.f. sputtering | 1.3 | 90% | high | Mainly amorphous |
| 24 | alloy of Cr (80at%) plus Si(20at%) | r.f. sputtering | 1.1 | 94% | high | Mainly amorphous |

TABLE 5

| No. | Substrate | Temperature of forming amorphous layer (1st process) (°C) | Temperature of diffusing amorphous layer (2nd process) (°C) | Crystal forms of boron deposited (3rd process) | Mechanical strength |
|---|---|---|---|---|---|
| 1 | W | – | – | β-rhombohedral | 100 |
| 2 | Ta | – | – | β-rhombohedral | 150 |
| 3 | Ta | – | – | Amorphous | 170 |
| 4 | Ta | 800 | 1300 | β-rhombohedral | 310 |
| 5 | Ta | 900 | 1300 | β-rhombohedral | 365 |
| 6 | Ta | 1000 | 1300 | β-rhombohedral | 500 |
| 7 | Ta | 1100 | 1300 | β-rhombohedral | 510 |
| 8 | Ta | 1200 | 1300 | β-rhombohedral | 290 |
| 9 | Ta | 1000 | 1100 | β-rhombohedral | 270 |
| 10 | Ta | 1000 | 1200 | β-rhombohedral | 470 |
| 11* | Ta | 1000 | 1300 | β-rhombohedral | 500 |
| 12 | Ta | 1000 | 1400 | β-rhombohedral | 300 |
| 13 | Ta | 1000 | 1300 | Amorphous | 570 |
| 14 | W | 1000 | 1300 | β-rhombohedral | 450 |

*Same as No. 6.

TABLE 6

| No. | Substrate | Crystal forms of boron firstly deposited | Thickness of firstly deposited crystal boron layer (microns) | Thickness of secondly deposited amorphous boron layer (microns) | Mechanical strength |
|---|---|---|---|---|---|
| 1 | W | all β-rhombohedral of 30 microns | | | 100 |
| 2 | Ta | all β-rhombohedral of 30 microns | | | 100 |
| 3 | Ta | all amorphous of 30 microns | | | 120 |
| 4 | Ta | β-rhombohedral | 3 | 28 | 500 |
| 5 | Ta | β-rhombohedral | 5 | 24 | 490 |
| 6 | Ta | β-rhombohedral | 10 | 20 | 390 |
| 7 | Ta | β-rhombohedral | 20 | 10 | 250 |
| 8 | Ta | β-rhombohedral + tetragonal | 2 | 28 | 470 |
| 9 | Ta | β-rhombohedral + tetragonal | 5 | 25 | 470 |
| 10 | Ta | β-rhombohedral + tetragonal | 10 | 20 | 350 |
| 11 | Ta | β-rhombohedral + tetragonal | 20 | 10 | 200 |
| 12 | W | β-rhombohedral | 6 | 24 | 390 |

TABLE 7

| No. | Substrate | Thickness of each amorphous layer (microns) | Number of amorphous layer in boron pipe | Mechanical strength | Comment |
|---|---|---|---|---|---|
| 1 | W | 60 | 1 | 100 | Crystal borons are likely to be formed locally, and boron pipe is weak, comparatively |
| 2 | Ta | 60 | 1 | 200 | |
| 3 | Ta | 2.3 | 26 | 490 | |
| 4 | Ta | 3.5 | 17 | 620 | |
| 5 | Ta | 5.1 | 12 | 635 | |
| 6 | Ta | 10.5 | 6 | 590 | |
| 7 | Ta | 15.0 | 4 | 550 | |
| 8 | Ta | 20.3 | 3 | 430 | Surface is a little non-uniform, and boron pipe is a little weak comparatively |
| 9 | W | 4.0 | 15 | 470 | |

## Claims

1. A method of producing a tubular boron body which comprises dissolving a wire body (1) having thereon at least one chemical vapour deposited layer (2) comprising amorphous boron, β-rhombohedral boron and/or tetragonal boron so as to leave the chemical vapour deposited layer intact in the form of a self-supporting tubular body, characterised in that the wire body is dissolved by means of a solution of at least one of bromine, iodine, iodine monochloride, iodine trichloride and iodine monobromide, such that the resultant tubular boron body is suitable for use as a pick-up cantilever.

2. A method according to claim 1, characterised in that the solvent for the solution is methanol and/or ethanol.

3. A method according to claim 1 or 2, characterised in that the boron layer formed by chemical vapour deposition is formed on a chromium-containing layer on the wire body.

4. A method according to claim 3, characterised in that the chromium-containing layer is of chromium, chromium boride, an alloy of chromium with iron, cobalt, nickel, or a boride of said alloy.

5. A method according to claim 4, characterised in that the alloy is chromium-iron having an iron content not exceeding 30 atom %, chromium-cobalt having a cobalt content not exceeding 20 atom % or chromium-nickel having a nickel content not exceeding 10 atom %.

6. A method according to any of claims 3 to 5, characterised in that the chromium-containing layer is 0.1 to 20 microns thick.

7. A method according to any of claims 1 to 6, characterised in that the wire body is of tantalum, tungsten, molybdenum or titanium.

8. A method according to any of claims 1 to 7, characterised in that, prior to chemical vapour deposition of the boron layer, an amorphous boron layer is deposited on the wire body and boron is diffused into the surface of the wire body to cause boride formation.

9. A method according to any of claims 1 to 8, characterised in that the wire body has thereon, in the order specified, a chemical vapour deposited layer of β-rhombohedral boron and/or tetragonal boron and at least one chemical vapour deposited layer of amorphous boron.

## Patentansprüche

1. Verfahren zur Herstellung eines rohrförmigen Körpers aus Bor, bei dem man einen Drahtkörper (1) mit mindestens einer chemisch aufgedampften Schicht (2) aus amorphem Bor, β-rhomboedrischem Bor und/oder tetragonalem

Bor darauf so auflöst, dass die chemisch aufgedampfte Schicht in Form eines selbsttragenden rohrförmigen Körpers unversehrt zurückbleibt, dadurch gekennzeichnet, dass man den Drahtkörper mittels einer Lösung von mindestens einem von Brom, Jod, Jodmonochlorid, Jodtrichlorid und Jodmonobromid so auflöst, dass der entstandene rohrförmige Borkörper zur Verwendung als Tonabnehmerarm geeignet ist.

2. Verfahren nach Anspruch 1, dadurch gekennzeichnet, dass das Lösungsmittel für die Lösung Methanol und/oder Aethanol ist.

3. Verfahren nach Anspruch 1 oder 2, dadurch gekennzeichnet, dass die durch chemisches Aufdampfen entstehende Borschicht auf einer chromhaltigen Schicht auf dem Drahtkörper gebildet wird.

4. Verfahren nach Anspruch 3, dadurch gekennzeichnet, dass die chromhaltige Schicht aus Chrom, Chrombromid, einer Chromlegierung mit Eisen, Kobalt oder Nickel oder aus einem Borid dieser Legierung besteht.

5. Verfahren nach Anspruch 4, dadurch gekennzeichnet, dass als Legierung Chromeisen mit einem 30 Atom-% nicht übersteigenden Eisengehalt, Chromkobalt mit einem 20.Atom-% nicht übersteigenden Kobaltgehalt oder Chromnickel mit einem 10 Atom-% nicht übersteigenden Nickelgehalt vorliegt.

6. Verfahren nach einem der Ansprüche 3 bis 5, dadurch gekennzeichnet, dass die chromhaltige Schicht eine Dicke von 0,1 bis 20 Mikron aufweist.

7. Verfahren nach einem der Ansprüche 1 bis 6, dadurch gekennzeichnet, dass der Drahtkörper aus Tantal, Wolfram, Molybdän oder Titan besteht.

8. Verfahren nach einem der Ansprüche 1 bis 7, dadurch gekennzeichnet, dass man vor dem chemischen Aufdampfen der Borschicht eine amorphe Borschicht auf dem Drahtkörper abscheidet und zur Boridbildung Bor in die Oberfläche des Drahtkörpers diffundieren lässt.

9. Verfahren nach einem der Ansprüche 1 bis 8, dadurch gekennzeichnet, dass der Drahtkörper in der angegebenen Reihenfolge auf sich eine chemisch aufgedampfte Schicht aus β-rhomboedrischem Bor und/oder tetragonalem Bor und mindestens eine chemisch aufgedampfte Schicht aus amorphem Bor aufweist.

**Revendications**

1. Procédé pour fabriquer un corps tubulaire en bore qui comprend la dissolution d'un corps en fil métallique (1) portant au moins une couche (2) formée par dépôt chimique à partir de la phase vapeur qui comprend du bore amorphe, du bore β-rhomboédrique et/ou du bore tétragonal de manière à laisser subsister la couche formée par dépôt chimique à partir de la phase vapeur intacte sous la forme d'un corps tubulaire autoportant, caractérisé en ce que le fil métallique est dissous au moyen d'une solution d'au moins l'un d'entre le brome, l'iode, le monochlorure d'iode, le trichlorure d'iode et le monobromure d'iode, de façon que le corps tubulaire en bore résultant convienne comme pointe de lecture du son.

2. Procédé suivant la revendication 1, caractérisé en ce que le solvant pour la solution est le méthanol et/ou l'éthanol.

3. Procédé suivant la revendication 1 ou 2, caractérisé en ce que la couche de bore formée par dépôt chimique à partir de la phase vapeur est formée sur une couche contenant du chrome sur le corps en fil métallique.

4. Procédé suivant la revendication 3, caractérisé en ce que la couche contenant du chrome est formée de chrome, de borure de chrome, d'un alliage de chrome avec le fer, le cobalt ou le nickel ou d'un borure de cet alliage.

5. Procédé suivant la revendication 4, caractérisé en ce que l'alliage est un chrome-fer ayant une teneur en fer qui n'excède pas 30 atomes pour cent, un chrome-cobalt ayant une teneur en cobalt qui n'excède pas 20 atomes pour cent ou un chrome-nickel ayant une teneur en nickel qui n'excède pas 10 atoms pour cent.

6. Procédé suivant l'une quelconque des revendications 3 à 5, caractérisé en ce que la couche contenant du chrome a une épaisseur de 0,1 à 20 μm.

7. Procédé suivant l'une quelconque des revendications 1 à 6, caractérisé en ce que le corps en fil métallique est en tantale, en tungstène, en molybdène ou en titane.

8. Procédé suivant l'une quelconque des revendications 1 à 7, caractérisé en ce qu'avant le dépôt chimique de la couche de bore à partir de la phase vapeur, une couche de bore amorphe est déposée sur le corps en fil métallique et le bore est introduit par diffusion dans la surface du corps en fil métallique pour provoquer la formation du borure.

9. Procédé suivant l'une quelconque des revendications 1 à 8, caractérisé en ce que le corps en fil métallique porte, dans l'ordre indiqué, une couche de bore β-rhomboédrique et/ou de bore tétragonal formée par dépôt chimique à partir de la phase vapeur et au moins une couche de bore amorphe formée par dépôt chimique à partir de la phase vapeur.

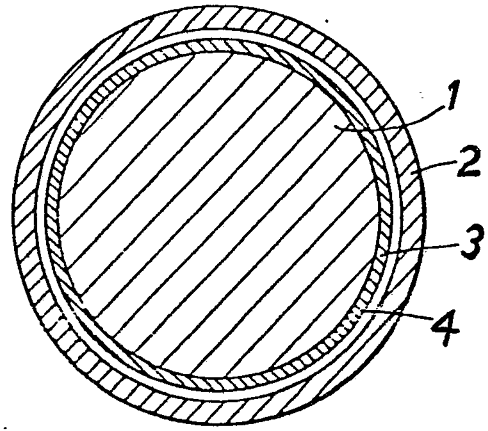


FIG. 1.

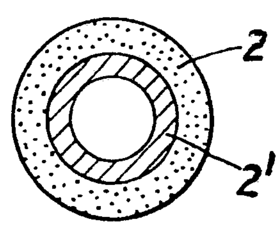


FIG. 2.